# EUROPEAN PATENT APPLICATION

(11) **EP 4 421 688 A1**
(43) Date of publication of application: **28.08.2024**
(21) Application number: 22938660.2
(22) Date of filing: 16.11.2022
(51) Int. Cl.: G06N 3/08, G06N 3/063, G06N 3/04, G06N 5/04

(54) **TRAINING APPARATUS AND METHOD FOR IMPLEMENTING EDGE ARTIFICIAL INTELLIGENCE DEVICE BY USING RESISTIVE ELEMENTS, AND ANALYSIS APPARATUS AND METHOD USING SAME**

(30) Priority: 19.04.2022 KR 20220048483
(71) Applicant: Postech Academy-Industry Foundation, Gyeongsangbuk-do, 37673 (KR)
(72) Inventor: HWANG, Hyun Sang, Daegu 42016 (KR); CHOI, Woo Seok, Hanam-si Gyeonggi-do 12945 (KR)
(74) Representative: BCKIP Part mbB
(86) International application number: PCT/KR2022/018066
(87) International publication number: WO 2023/204371

(57) **Abstract**

A learning apparatus and method for implementing an edge device using a resistive element and an analysis apparatus and method using the same are disclosed. The learning apparatus for implementing an edge device using a resistive element according to an embodiment of the present application may include a first learning unit determining a weight of an artificial neural network through learning based on first training data and reflecting the determined weight in a first resistive element, and a second learning unit updating the weight of the artificial neural network through learning based on second training data collected through the device and reflecting the updated weight in the second resistive element.

## Description

### [Technical Field]

The present disclosure relates to a machine-learning apparatus and method for implementing an artificial intelligence edge device using resistive elements and an analysis apparatus and method using the same.

### [Background Art]

With the development of deep neural networks, artificial intelligence (AI) has shown remarkable achievements in real-world applications such as object and signal classification, and with the advent of the Internet of Things (IoT), locations, where artificial intelligence services are implemented, tend to be shifted from a cloud to an edge. However, unlike in cloud computing, numerous training parameters and power constraints of neural networks cause significant problems in implementing artificial intelligence based on edge computing.

Therefore, recent edge computing-based artificial intelligence hardware is generally implemented to perform inference only in a form specialized for application-specific tasks, but since inference-only artificial intelligence services are easily affected by changes in the environment in which a device is actually used, there is a problem in that even small changes may cause serious loss of accuracy.

In addition, most conventional hardware neural networks are implemented in the form that each synapse weight is fixed depending on the purpose of use, so there is a limitation in that they may not reflect the changes in the environment in which the device is actually used.

For example, since inference results based on edge artificial intelligence services applied to biomedical applications such as electrocardiogram signal (ECG) classification are likely to output signal patterns with large errors from the actually measured biosignals, there is an increasing need for the development of artificial intelligence sensors that can be cost-effectively trained and detect input signals with high precision.

The background technology of the present disclosure is disclosed in Korean Patent No. 10-1686827.

### [Disclosure]

### [Technical Problem]

The present application is intended to solve the problems of the related art described above, and an object of the present application is to provide a learning apparatus and method for implementing an edge device using a resistive element that implements a neural network in hardware using a fixed resistive element and a programmable non-volatile memory device by using a fixed resistive element and a programmable non-volatile memory device to enable efficient learning and inference of artificial intelligence in the edge device using a resistive synapse element, and an analysis apparatus and method using the same.

The present application is intended to solve the problems of the related art described above, and an object of the present application is to provide a learning apparatus and method for implementing an edge device using a resistive element by enabling an artificial intelligence model to be implemented in an edge-based environment with variable usage environments related to various fields such as real life, medicine, and commerce, and an analysis apparatus and method using the same.

This application is intended to solve the problems of the related art described above, and an object of the present application is to increase accuracy and efficiency of learning of an artificial intelligence chip operating at an edge by using a fixed-resistor synapse to implement a synapse with high-resolution weights in a deep and complex deep neural network, but by implementing the synapse with a non-volatile memory device capable of programming only some of the weights.

However, the technical problems to be achieved by the embodiments of the present application are not limited to the technical problems as described above, and other technical problems may exist.

### [Technical Solution]

According to an aspect of the present disclosure, a learning apparatus for implementing an edge device using a resistive element may include a first learning unit determining a weight of an artificial neural network through learning based on first training data and reflecting the determined weight in a first resistive element, and a second learning unit updating the weight of the artificial neural network through learning based on second training data collected through the device and reflecting the updated weight in the second resistive element.

The first resistive element may include a fixed resistive element.

The second resistive element includes a non-volatile memory device.

The first learning unit may include a plurality of first resistive elements arranged in an array form.

The second learning unit may include a plurality of second resistive elements arranged in the array form.

At least one of a width, a length, and a cross-sectional area of the fixed resistive element may be determined based on a size of the determined weight.

The fixed resistive element may include a metal oxide layer or may be formed of a material selected from the group consisting of Si, Ni, Cr, Al, Ta, and combinations thereof.

The programmable non-volatile memory device may include at least one of a NAND flash memory device, a NOR flash memory device, a phase-change random access memory (PCRAM) device, a resistive random-access memory (RRAM) device, a ferroelectric random access memory (FRAM) device, and a magnetic random access memory (MRAM) device.

The RRAM device may have a structure in which a first metal layer, an insulator layer, and a second metal layer are vertically stacked.

The first training data and the second training data may be electrocardiogram signal data. The artificial neural network may be trained to perform inference to classify characteristics of analysis target data, which is electrocardiogram signal data collected through the device, into a preset category.

According to another aspect of the present disclosure, an analysis apparatus based on an artificial neural network using a resistive element may include a first learning unit determining a weight of an artificial neural network through learning based on first training data and reflecting the determined weight in a first resistive element, a second learning unit updating the weight of the artificial neural network through learning based on second training data collected through the device, and reflecting the updated weight in the second resistive element, and an inference unit acquiring analysis target data using the device and performing inference on the analysis target data based on the artificial neural network.

According to still another aspect of the present disclosure, a learning method for implementing an edge device using a resistive element may include determining a weight of an artificial neural network through learning based on first training data and reflecting the determined weight in a first resistive element, and updating the weight of the artificial neural network through learning based on second training data collected through the device and reflecting the updated weight in the second resistive element.

According to yet another aspect of the present disclosure, an analysis method based on an artificial neural network using a resistive element may include determining a weight of an artificial neural network through learning based on first training data and reflecting the determined weight in a first resistive element, updating the weight of the artificial neural network through learning based on second training data collected through the device and reflecting the updated weight in the second resistive element, and acquiring analysis target data using the device and performing inference on the analysis target data based on the artificial neural network.

The means for solving the problem described above are merely exemplary and should not be construed as limiting the present application. In addition to the embodiments described above, additional embodiments may exist in the drawings and detailed description of the disclosure.

### [Advantageous Effects]

According to the technical solution of the present application described above, the present application is intended to solve the problems of the related art described above, and it is possible to provide a learning apparatus and method for implementing an edge device using a resistive element that implements a neural network in hardware using a fixed resistive element and a programmable non-volatile memory device by using a fixed resistive element and a programmable non-volatile memory device to enable efficient learning and inference of artificial intelligence in the edge device using a resistive synapse element.

According to the technical solution of the present application described above, it is possible to provide a learning apparatus and method for implementing an edge device using a resistive element by enabling an artificial intelligence model to be implemented in an edge-based environment with variable usage environments related to various fields such as real life, medicine, and commerce.

According to the technical solution of the present application described above, it is possible to implement a network responsible for basic major cores based on a stable fixed resistance, and implement an edge AI chip capable of stably performing high-performance learning by partially using a non-volatile memory device whose resistance can change.

According to the technical solution of the present application described above, it is possible to increase accuracy and efficiency of learning of an artificial intelligence chip operating at an edge by using a fixed-resistor synapse to implement a synapse with high-resolution weights in a deep and complex deep neural network, but by implementing the synapse with a non-volatile memory device capable of programming only some of the weights.

However, the effects obtainable herein are not limited to the effects described above, and other effects may exist.

### [Description of Drawings]

FIG. 1 is a schematic configuration diagram of an artificial neural network-based analysis system according to an embodiment of the present application.
FIGS. 2 and 3 are conceptual diagrams for describing a process of learning an artificial neural network using a resistive element according to an embodiment of the present application.
FIG. 4 is a conceptual diagram for describing a parallel connection type and serial connection method of a first learning unit and a second learning unit.
FIG. 5 is a diagram illustrating a detailed structure of a first resistive element.
FIG. 6 is a diagram illustrating an array structure including a plurality of first resistive elements and a change in characteristics of the array structure.
FIG. 7 is a diagram illustrating a process of extracting main features of a normal signal and an abnormal signal using discrete wavelet transform (DWT).
FIG. 8. is a diagram illustrating a) WOx deposition condition b) Specified condition for nano-resistor with few mega ohms.
FIG. 9 is a diagram illustrating a detailed structure of a second resistive element.
FIG. 10. is diagram illustrating a) VForming distribution and b) I-V curve measured across the entire wafer.
FIG. 11 is a conceptual diagram for describing an artificial neural network for inference that classifies electrocardiogram (ECG) signal data into preset categories.
FIG. 12 is a graph comparing the accuracy and efficiency in an edge environment of an artificial neural network implemented only with a fixed resistive element and an artificial neural network performing partial weight learning using a non-volatile memory device.
FIG. 13 is a schematic configuration diagram of an apparatus for learning an artificial neural network using a resistive element according to an embodiment of the present application.
FIG. 14 is a schematic configuration diagram of an analysis apparatus based on an artificial neural network using a resistive element according to an embodiment of the present application.
FIG. 15 is an operation flowchart of a learning method based on an artificial neural network using a resistive element according to an embodiment of the present application.
FIG. 16 is an operation flowchart of an analysis method based on an artificial neural network using a resistive element according to an embodiment of the present application.

### [Best Mode]

Hereinafter, embodiments of the present disclosure will be described in detail with reference to the accompanying drawings so that those skilled in the art to which the present disclosure pertains may easily practice. However, the present disclosure may be implemented in various different forms, and is not limited to the embodiments described herein. In addition, in the drawings, portions unrelated to the description will be omitted to clearly describe the present disclosure, and similar portions will be denoted by similar reference numerals throughout the specification.

In addition, throughout the present specification, when any one part is referred to as being "connected to" another part, it means that any one part and another part are "directly connected to" each other or are "electrically connected to" or "indirectly connected to" each other with the other part interposed therebetween.

Throughout the present specification, when any member is referred to as being positioned "on", "at an upper portion", "at an upper end", "below", "at a lower portion", "at a lower end" of another member, it includes not only a case in which any member and another member are in contact with each other, but also a case in which the other member is interposed between any member and another member.

Through the present specification and claims, unless explicitly described otherwise, "comprising" any components will be understood to imply the inclusion of other components rather than the exclusion of any other components.

The present application relates to a learning apparatus and method for implementing an edge device using a resistive element and an analysis apparatus and method using the same.

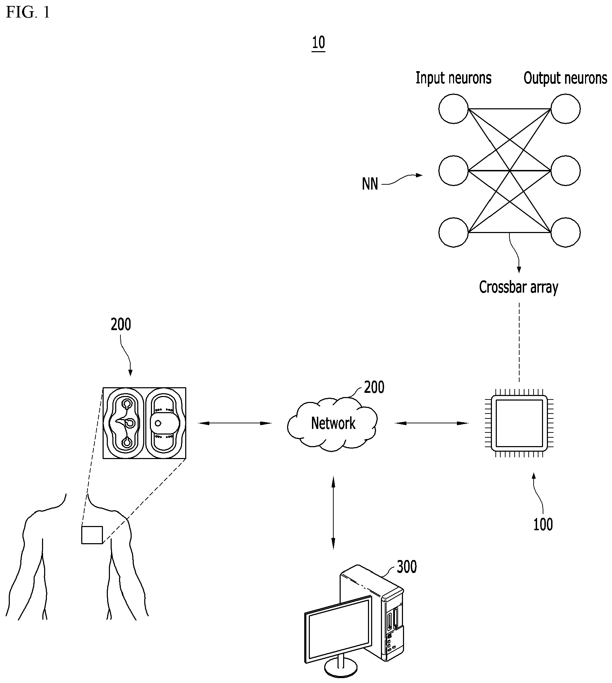

FIG. 1 is a schematic configuration diagram of an artificial neural network-based analysis system according to an embodiment of the present application.

Referring to FIG. 1, an artificial neural network-based analysis system 10 according to an embodiment of the present application may include an apparatus 100 for learning an artificial neural network using a resistive element (hereinafter referred to as `learning apparatus 100') according to an embodiment of the present application, a device 200, and a user terminal 300.

The user terminal 300 may be, for example, a smart phone, a smart pad, a tablet PC, etc., and all types of wireless communication devices such as personal communication system (PCS), global system for mobile communication (GSM), personal digital cellular (PDC), personal handyphone system (PHS), personal digital assistant (PDA), international mobile telecommunication (IMT)-2000, code division multiple access (CDMA)-2000, W-code division multiple access (W-CDMA), and wireless broadband Internet (Wibro) terminals. For reference, in the description of the embodiment of the present application, the user terminal 300 refers to a device that performs learning of software (SW)-based artificial neural network based on first training data including open source data, etc., and may be distinguished from the device 200 herein, which operates to update a weight of the artificial neural network based on second training data and perform inference on analysis target data using the artificial neural network with the updated weight.

Meanwhile, in the description of the embodiment of the present application, the analysis apparatus 100' based on an artificial neural network using a resistive element (hereinafter referred to as `analysis apparatus 100") may perform inference on the analysis target data acquired by the analysis apparatus 100'. In other words, in the description of the embodiment of the present application, the learning apparatus 100 and the analysis apparatus 100' may commonly include a sub-configuration for learning an artificial neural network using a resistive element, and in the following description, for convenience of description, the embodiment of the present application will be described based on a construction of an artificial neural network (NN in FIG. 1) by the learning apparatus 100.

In addition, in the description of the embodiment of the present application, the device 200 may refer to an Internet of Things-based edge device. For example, the device 200 is a device for measuring analysis target data to perform the inference for the artificial neural network, and the inference (analysis) on the analysis target data collected in the device 200 may be directly performed on the device 200 end by the analysis apparatus 100' mounted on the device 200 without being transmitted to a separate external server or database.

In addition, according to the embodiment of the present application, the learning apparatus 100 or the analysis apparatus 100' may be mounted on the device 200 in the form of a chip implementing an artificial intelligence function in a hardware manner.

For example, the device 200 may be a wearable device such as a smart watch or a smart band for collecting user's biometric information, etc., while attached to or worn on a user's body, but is not limited thereto. As another example, the device 200 may broadly refer to a device that may be worn in various locations, such as a head-worn device, a strap-type device, a clothing-type device, and a shoe-won/foot pods device, to acquire the user's biometric information. In addition, by way of example, the device 200 may be Fitbit, Jawbone Up, Nike+ FuelBand, Apple Watch, Samsung Gear, etc. In addition, the wearable device 200 and the user terminal 300 may be linked to each other based on the same account information on one user. In addition, according to the implementation example of the present application, the device 200 may be understood as being included in the user terminal 300 in a broad scope.

More specifically, according to the embodiment of the present application, the device 200 may be a biometric measurement terminal that is attached to the user's body and acquires user's electrocardiogram signal data (e.g., ECG data, etc.). In this regard, according to the embodiment of the present application, the first training data and the second training data for learning of the artificial neural network, and the analysis target data that is collected through the device 200 and subject to the inference (analysis) by the artificial neural network may be the ECG data. In response to this, the artificial neural network may be trained to perform the inference to classify the characteristics of the analysis target data, which is the ECG data, into preset categories.

For example, the artificial neural network (NN in FIG. 1) may be trained to perform the inference to classify the analysis target data, which is the ECG data, into any one of a plurality of categories including a normal signal N, a premature ventricular contraction (PVC) signal, a left bundle branch block (LBBB) signal, a right bundle branch block (RBBB) signal, etc.

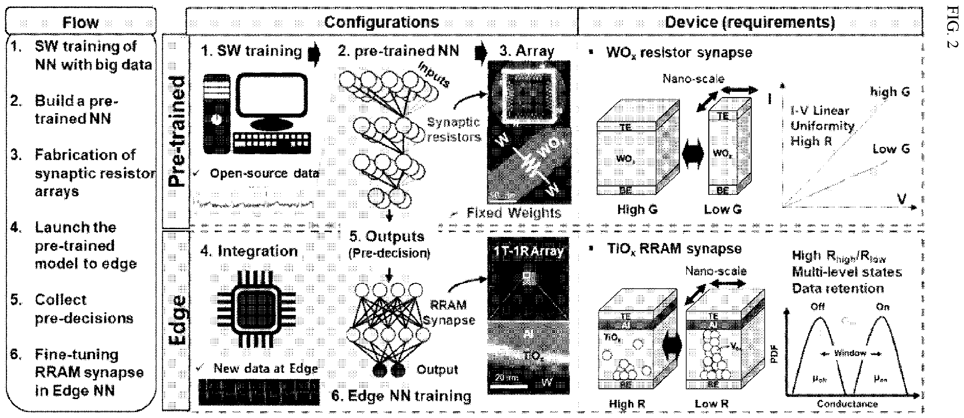

Hereinafter, specific functions and operations of the learning apparatus 100 will be described with reference to FIGS. 2 to 11.

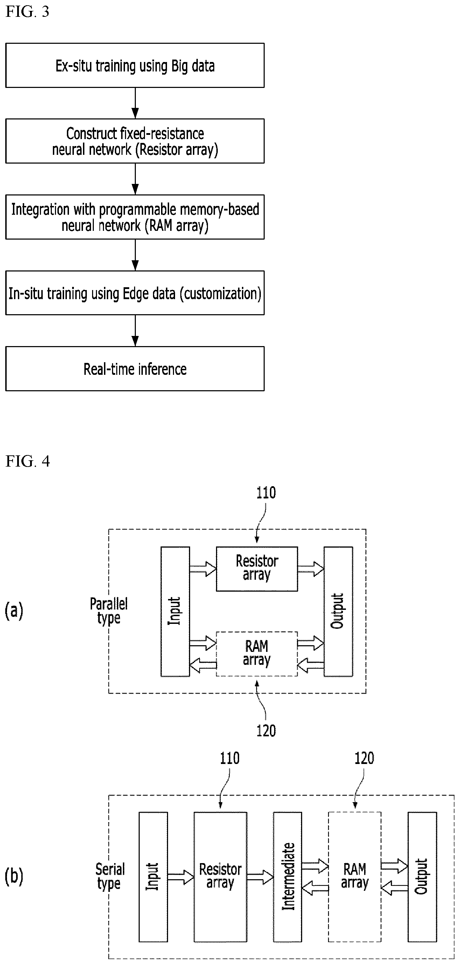

FIGS. 2 and 3 are conceptual diagrams for describing a process of learning an artificial neural network using a resistive element according to an embodiment of the present application.

Referring to FIGS. 2 and 3, the learning apparatus 100 may determine the weight of the artificial neural network (NN) through learning based on the first training data, and reflect the determined weight in a first resistive element 111. In this regard, in the description of the embodiment of the present application, the first resistive element may include a fixed resistive element. In addition, according to the embodiment of the present application, the learning apparatus 100 may include a plurality of first resistive elements arranged in an array form.

Referring to FIGS. 2 and 3, the learning apparatus 100 may implement a weight map acquired through ex-situ training using the first training data as an array (`resistor array' in FIG. 3) composed of fixed resistive elements to implement a synaptic resistor of the neural network.

According to the embodiment of the present application, the first training data may be, for example, open-source data, and the learning based on the first training data may refer to, for example, software (SW)-based learning performed using the user terminal 300, etc. In addition, in this regard, the neural network constructed in such a way that the weight (or weight map) derived as the learning result based on the first training data is reflected in the fixed resistive element, which is the first resistive element 111, may be referred to as a pre-trained NN (NNi).

In this regard, in order to improve the accuracy of the artificial neural network, the learning apparatus disclosed herein 100 may primarily construct a pre-trained neural network using the first resistive element 111, which corresponds to a main core that cannot be programmed later, and update at least some weights in the pre-trained neural network using data (second training data, `new data at edge' in FIG. 2) collected at an edge device end using a second resistive element corresponding to a programmable sub-core as described in detail below, so the constructed artificial neural network may be implemented to perform the inference with greater accuracy in the edge environment of the device 200.

In other words, after the weight of the pre-trained neural network is reflected (recorded) in the first resistive element 111, the learning apparatus 100 may update the weight of the artificial neural network through learning based on the second training data collected through the device 200 and reflect the updated weight in the second resistive element.

According to the embodiment of the present application, the second resistive element may include a non-volatile memory device capable of changing resistance and thus changing the weight. That is, the learning apparatus 100 may update the weight or weight map through in-situ training using the second training data collected in an actual edge environment through the device 200.

In addition, according to the embodiment of the present application, the learning apparatus 100 may include a plurality of second resistive elements (`RAM array' in FIG. 3) arranged in the array form.

Among the resistive elements for implementing the weights of the artificial neural network, the programmable non-volatile memory device may provide persistent data by retaining stored data when power is not supplied. Specifically, examples of the programmable non-volatile memory device may include a NAND flash memory device, a NOR flash memory device, a phase-change random access memory (PCRAM) device, a resistive random-access memory (RRAM) device, a ferroelectric random access memory (FRAM) device, and a magnetic random access memory (MRAM) device, etc.

For example, the non-volatile memory device may be the resistive random access memory (RRAM) device composed of a metal-insulator (electrolyte)-metal (MIM) vertical structure capable of high integration. In addition, in response to this, the fixed resistive element may also be manufactured by a resistance with a vertical structure corresponding to the RRAM, thereby implementing a high-density synapse array of 4F2.

In addition, according to the embodiment of the present application, the programmable non-volatile memory device may include the resistive random-access memory (RRAM) device, and this RRAM device may be provided in a structure in which a first metal layer, an insulator layer, and a second metal layer are vertically stacked.

FIG. 4 is a conceptual diagram for describing a parallel connection type and serial connection method of a first learning unit and a second learning unit.

Referring to FIG. 4, the array (resistor array) configured of the fixed resistive elements of the learning apparatus 100 and the array (RAM array) configured of the non-volatile memory device may be mutually integrated in the parallel type (see (a) of FIG. 4), or may be mutually integrated in the serial type (see of (b) of FIG. 4).

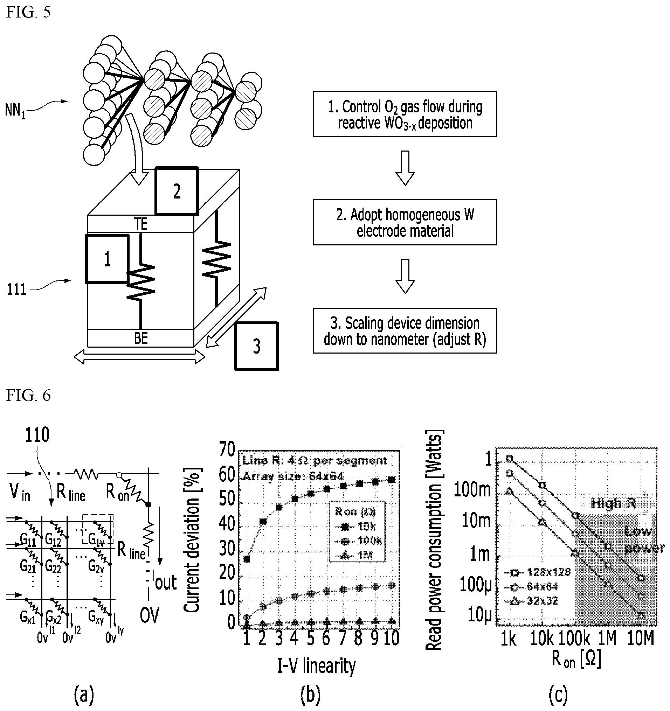

FIG. 5 is a diagram illustrating a detailed structure of the first resistive element.

Referring to FIG. 5, the first resistive element corresponding to the fixed resistive element includes a metal oxide layer or may be formed of materials selected from the group consisting of silicon (Si), nickel (Ni), chromium (Cr), aluminum (Al), tantalum (Ta), and combinations thereof. For example, the metal oxide layer may include, but is not limited to, a tungsten oxide (WOₓ) layer, a titanium oxide (TiOₓ) layer, and a molybdenum oxide (MoOₓ) layer.

In a more specific example, the first resistive element may be formed of a material including a tungsten oxide layer. In addition, referring to FIG. 5, at least one of the width, length, and cross-sectional area of each fixed resistive element included in the fixed resistive element array may be determined based on the weight sizes of each synapse determined through the learning using the first training data.

In this regard, in order to implement the pre-trained neural network using the first training data, the weights should be reflected in the fixed resistive element array. As a result, in order to implement a high-precision neural network with low power, the resistive element with high linearity is required. In this regard, the WOₓ layer (film) is advantageous in that it exhibits conductivity suitable for manufacturing MΩ-level nanoscale resistance with high I-V linearity during sputtering. In particular, the fixed resistive element disclosed herein uses a tungsten (W) electrode with low electronegativity, so it is possible to greatly improve conductivity uniformity through contact between the electrode and the tungsten oxide layer.

FIG. 6 is a diagram illustrating an array structure including the plurality of first resistive elements and the change in characteristics of the array structure.

Specifically, (a) of FIG. 6 and (b) of FIG. 6 illustrate simulation data based on measurement data of the array of the actual fixed resistive element in which parasitic effects exist, in which it can be seen that the parasitic effects are reduced by the high resistance value and linearity realized through the tungsten oxide layer. Referring to (c) of FIG. 6, it can be seen that the reduction in the parasitic effects is a very important element in implementing the artificial neural network on the energy-efficient edge device side.

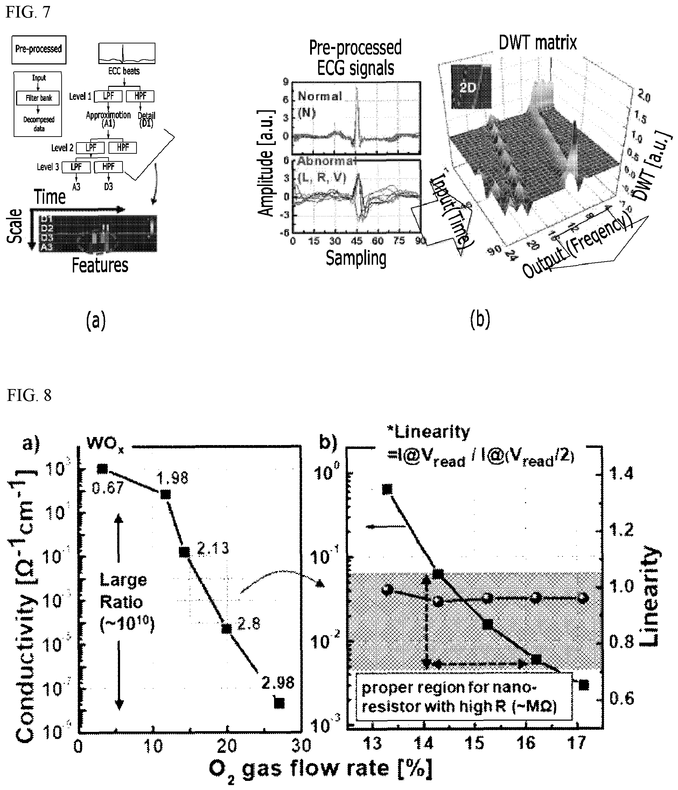

FIG. 7 is a diagram illustrating a process of extracting main features of a normal signal and an abnormal signal using discrete wavelet transform (DWT).

Referring to FIG. 7, when implementing a pre-trained neural network using a synaptic resistor including a tungsten oxide layer, the characteristics of the signal data included in the training data may be extracted through discrete wavelet transform through multi-scale frequency analysis, and (b) of FIG. 7 illustrates that this discrete wavelet transform (DWT) matrix is visualized.

FIG. 8. is a diagram illustrating a) WOx deposition condition b) Specified condition for nano-resistor with few mega ohms.

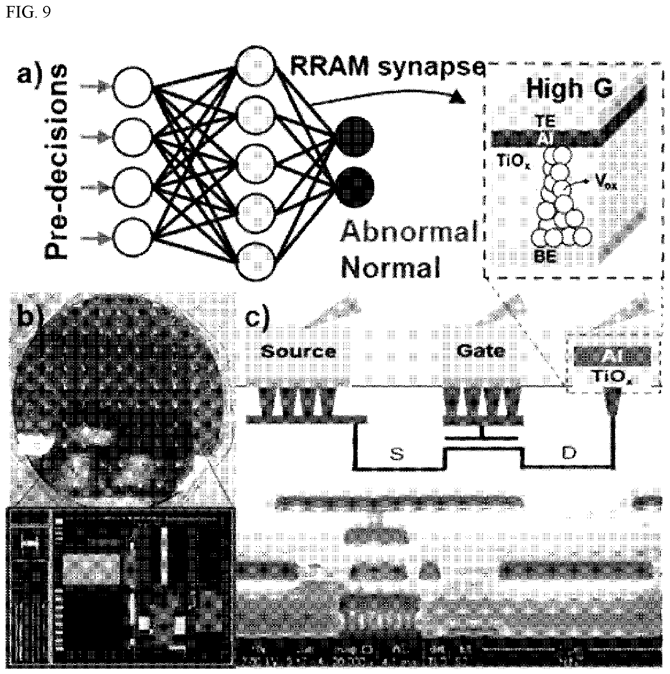

FIG. 9 is a diagram illustrating a detailed structure of a second resistive element.

Referring to FIG. 9, the second resistive element may be a TiOₓ RRAM synapse element and may be implemented on a wafer.

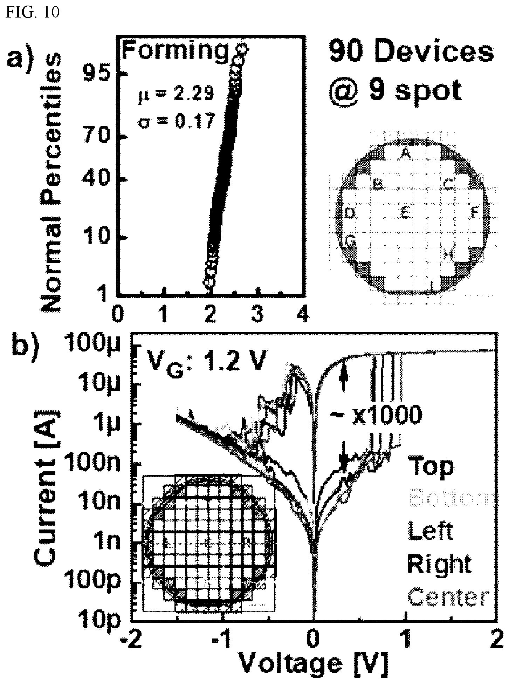

FIG. 10. is diagram illustrating a) VForming distribution and b) I-V curve measured across the entire wafer.

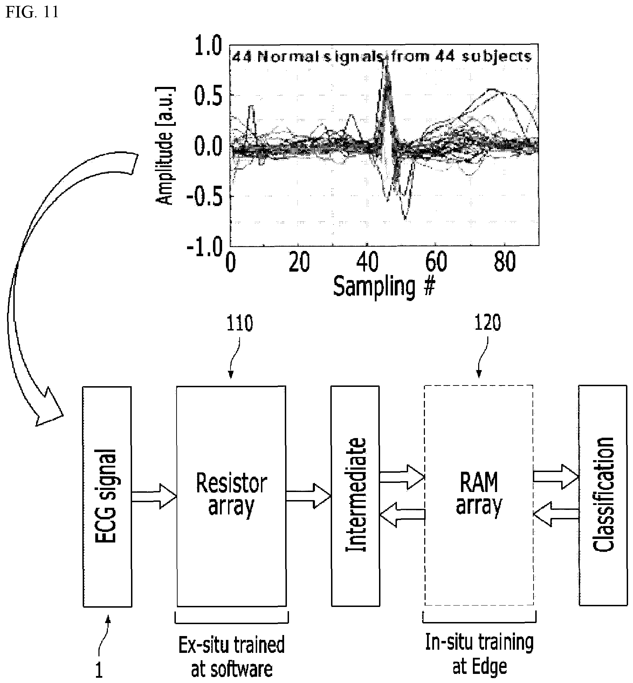

FIG. 11 is a conceptual diagram for describing an artificial neural network for inference that classifies ECG data into preset categories.

Referring to FIG. 11, the artificial neural network constructed by the learning apparatus 100 may be trained to perform the inference to classify the characteristics of the analysis target data, which is the ECG data collected through the device 200, into preset categories.

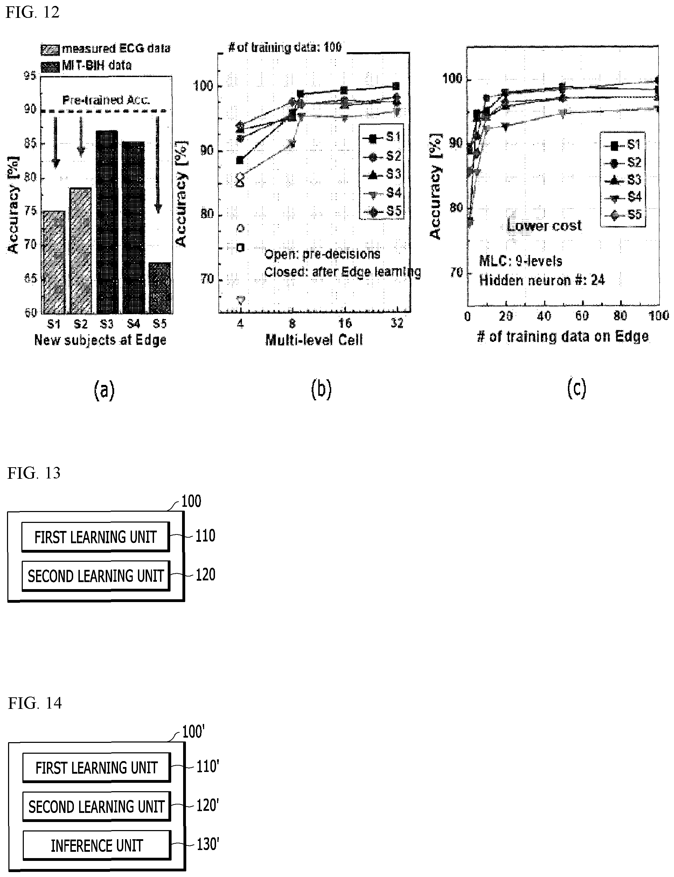

FIG. 12 is a graph comparing the accuracy and efficiency in an edge environment of an artificial neural network implemented only with a fixed resistive element and an artificial neural network performing partial weight learning using a non-volatile memory device.

Referring to (a) of FIG. 12, when performing the inference using the data actually collected in the edge environment, it can be seen that the accuracy of the pre-trained neural network (in other words, the neural network implemented only with the fixed resistive element to which the weight update using the programmable non-volatile memory device is not applied) is greatly reduced compared to the target accuracy level achieved during the learning. This may be interpreted because patterns of collecting biological signals may be very different depending on the subject (targeted person).

In this regard, referring to (b) of FIG. 12, it can be seen that the accuracy performance of the artificial neural network to which the weight update (edge learning) using the non-volatile memory device is applied is improved in most aspects compared to the pre-trained neural network, and it can be seen that even when the artificial neural network has relatively few cell levels (e.g., 8 levels, etc.), the accuracy performance is significantly improved. In addition, referring to (c) of FIG. 12, by updating only part of the weight of the pre-trained neural network using data (second training data) actually collected on the edge side rather than updating the entire weight, the accuracy performance may be improved, so it can be seen that significant accuracy performance improvement can be achieved with only relatively small training data of about 20.

FIG. 13 is a schematic configuration diagram of an apparatus for learning an artificial neural network using a resistive element according to an embodiment of the present application.

Referring to FIG. 13, the learning apparatus 100 may include a first learning unit 110 and a second learning unit 120.

The first learning unit 110 may determine the weight of the artificial neural network through the learning based on the first training data, and reflect the determined weight in the first resistive element 111.

The second learning unit 120 may collect the second training data through the device 200 and update the weight of the artificial neural network through the learning based on the second training data. In addition, the second learning units 120 and 120' may reflect the updated weight in the second resistive element.

FIG. 14 is a schematic configuration diagram of the analysis apparatus based on an artificial neural network using a resistive element according to an embodiment of the present application.

Referring to FIG. 14, the analysis apparatus 100' may include a first learning unit 110', a second learning unit 120', and an inference unit 130'. Meanwhile, in the description of the embodiment of the present application, the first learning unit 110' and the second learning unit 120' of the analysis apparatus 100' are sub-modules that perform equivalent functions to the first learning unit 110 and the second learning unit 120 of the above-described learning apparatus 100, respectively, and therefore, description thereof will be omitted.

The inference unit 130' may acquire the analysis target data using the device 200, and perform the inference on the analysis target data based on the artificial neural network constructed by the first learning unit 110' and the second learning unit 120'.

According to the embodiment of the present application, when the first training data, the second training data, and the analysis target data are the subject's ECG data type, the inference unit 130' may perform the inference to classify the characteristics of the analysis target data, which is the ECG data collected through the device 200, into the preset categories using the constructed artificial neural network.

Hereinafter, the operation flow of the present disclosure will be briefly described based on the details described above.

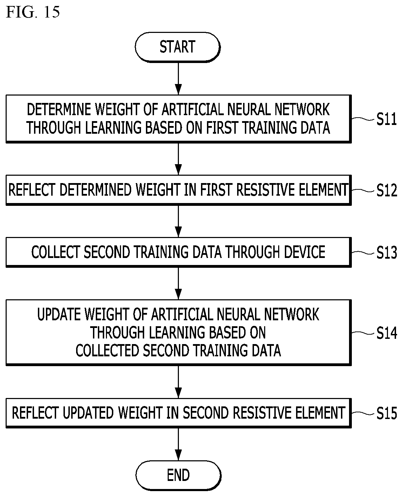

FIG. 15 is an operation flowchart of the learning method based on an artificial neural network using a resistive element according to an embodiment of the present application.

The learning method based on an artificial neural network using a resistive element illustrated in FIG. 15 may be performed by the learning apparatus 100 or the analysis apparatus 100' described above. Therefore, even if the contents are omitted below, the content described about the learning apparatus 100 or the analysis apparatus 100' may be equally applied to the description of the learning method based on an artificial neural network using a resistive element.

Referring to FIG. 15, in step S11, the first learning units 110 and 110' may determine the weight of the artificial neural network through the learning based on the first training data.

Next, in step S12, the first learning units 110 and 110' may reflect the weight determined in step S11 in the first resistive element 111.

Next, in step S13, the second learning units 120 and 120' may collect the second training data through the device 200.

Next, in step S14, the second learning units 120 and 120' may update the weight of the artificial neural network through the learning based on the second training data.

Next, in step S15, the second learning units 120 and 120' may reflect the updated weight in the second resistive element.

In the above description, steps S11 to S15 may be further divided into additional steps or combined into fewer steps, according to the implementation example of the present application. Also, some steps may be omitted if necessary, and an order between operations may be changed.

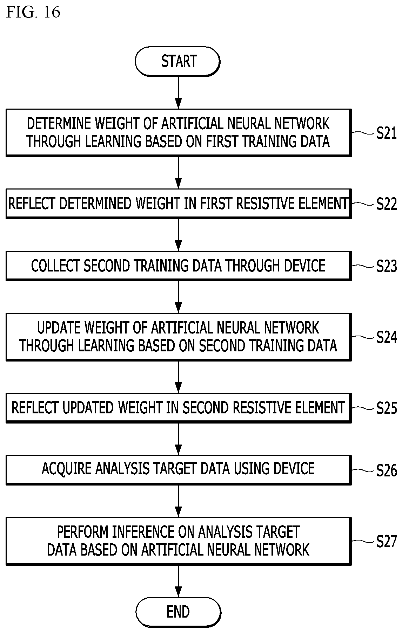

FIG. 16 is an operation flowchart of an analysis method based on an artificial neural network using a resistive element according to an embodiment of the present application.

The analysis method based on an artificial neural network using a resistive element illustrated in FIG. 16 may be performed by the analysis apparatus 100' described above. Therefore, even if the contents are omitted below, the content described about the analysis apparatus 100' may be equally applied to the description of the analysis method based on an artificial neural network using a resistive element.

Referring to FIG. 16, in step S21, the first learning unit 110' may determine the weight of the artificial neural network through the learning based on the first training data.

Next, in step S22, the first learning unit 110' may reflect the weight determined in step S21 in the first resistive element 111.

Next, in step S23, the second learning unit 120' may collect the second training data through the device 200.

Next, in step S24, the second learning unit 120' may update the weight of the artificial neural network through the learning based on the second training data.

Next, in step S25, the second learning unit 120' may reflect the updated weight in the second resistive element.

Next, in step S26, the inference unit 130' may acquire the analysis target data using the device 200.

Next, in step S27, the inference unit 130' may perform the inference on the analysis target data based on the constructed artificial neural network.

In the above description, steps S22 to S27 may be further divided into additional steps or combined into fewer steps, according to the implementation example of the present disclosure. Also, some steps may be omitted if necessary, and an order between operations may be changed.

The learning method based on an artificial neural network using a resistive element or an analysis method based on an artificial neural network using a resistive element according to an embodiment of the present application may be implemented in the form of program instructions that may be executed through various computer means and may be recorded on a computer-readable medium. The computer-readable recording medium may include a program instruction, a data file, a data structure or the like, alone or a combination thereof. The program commands recorded in the computer-readable recording medium may be specially designed and configured for the present disclosure or be known to those skilled in a field of computer software. Examples of the computer-readable recording medium may include a magnetic medium such as a hard disk, a floppy disk, or a magnetic tape, an optical medium such as a compact disk read only memory (CD-ROM) or a digital versatile disk (DVD), a magneto-optical medium such as a floptical disk, and a hardware device specially configured to store and execute program commands, such as a ROM, a random access memory (RAM), a flash memory, or the like. Examples of the program commands include a high-level language code capable of being executed by a computer using an interpreter, or the like, as well as a machine language code made by a compiler. The above-described hardware device may be configured to be operated as one or more software modules to perform an operation according to the present disclosure, and vice versa.

In addition, the above-described learning method based on an artificial neural network using a resistive element or analysis method based on an artificial neural network using a resistive element may also be implemented in the form of computer programs or applications executed by a computer stored on a recording medium.

The above description of the present disclosure is for illustrative purposes, and those skilled in the art to which the present disclosure pertains will understand that it is possible to be easily modified to other specific forms without changing the technical spirit or essential features of the present disclosure. Therefore, it should be understood that the above-mentioned embodiments are exemplary in all aspects but are not limited thereto. For example, each component described as a single type may be implemented in a distributed manner, and similarly, components described as distributed may be implemented in a combined form.

It is to be understood that the scope of the present disclosure will be defined by the claims rather than the above-mentioned description and all modifications and alternations derived from the claims and their equivalents are included in the scope of the present disclosure.

## Claims

1. A learning apparatus for implementing an edge device using a resistive element, comprising:
a first learning unit determining a weight of an artificial neural network through learning based on first training data and reflecting the determined weight in a first resistive element; and
a second learning unit updating the weight of the artificial neural network through learning based on second training data collected through the device and reflecting the updated weight in a second resistive element.

2. The learning apparatus of claim 1, wherein the first resistive element includes a fixed resistive element, and
the second resistive element includes a programmable non-volatile memory device.

3. The learning apparatus of claim 1, wherein the first learning unit includes a plurality of first resistive elements arranged in an array form, and
the second learning unit includes a plurality of second resistive elements arranged in the array form.

4. The learning apparatus of claim 2, wherein at least one of a width, a length, and a cross-sectional area of the fixed resistive element is determined based on a size of the determined weight.

5. The learning apparatus of claim 2, wherein the fixed resistive element includes a metal oxide layer or is formed of a material selected from the group consisting of Si, Ni, Cr, Al, Ta, and combinations thereof.

6. The learning apparatus of claim 2, wherein the programmable non-volatile memory device includes at least one of a NAND flash memory device, a NOR flash memory device, a phase-change random access memory (PCRAM) device, a resistive random-access memory (RRAM) device, a ferroelectric random access memory (FRAM) device, and a magnetic random access memory (MRAM) device.

7. The learning apparatus of claim 6, wherein the RRAM device has a structure in which a first metal layer, an insulator layer, and a second metal layer are vertically stacked.

8. The learning apparatus of claim 1, wherein the first training data and the second training data are electrocardiogram signal data, and
the artificial neural network is trained to perform inference to classify characteristics of analysis target data, which is the electrocardiogram signal data collected through the device, into a preset category.

9. An analysis apparatus based on an artificial neural network using a resistive element, comprising:
a first learning unit determining a weight of the artificial neural network through learning based on first training data and reflecting the determined weight in a first resistive element;
a second learning unit updating the weight of the artificial neural network through learning based on second training data collected through a device, and reflecting the updated weight in the second resistive element; and
an inference unit acquiring analysis target data using the device and performing inference on the analysis target data based on the artificial neural network.

10. A learning method for implementing an edge device using a resistive element, comprising:
determining a weight of an artificial neural network through learning based on first training data and reflecting the determined weight in a first resistive element; and
updating the weight of the artificial neural network through learning based on second training data collected through the device and reflecting the updated weight in the second resistive element.

11. The learning method of claim 10, wherein the first resistive element includes a fixed resistive element, and
the second resistive element includes a programmable non-volatile memory device.

12. The learning method of claim 10, wherein the first resistive element is provided in plural pieces arranged in an array form, and
the second resistive element is provided in plural pieces arranged in the array form.

13. The learning method of claim 11, wherein at least one of a width, a length, and a cross-sectional area of the fixed resistive element is determined based on a size of the determined weight.

14. The learning method of claim 11, wherein the fixed resistive element includes a metal oxide layer or is formed of a material selected from the group consisting of Si, Ni, Cr, Al, Ta, and combinations thereof.

15. The learning method of claim 11, wherein the programmable non-volatile memory device includes at least one of a NAND flash memory device, a NOR flash memory device, a phase-change random access memory (PCRAM) device, a resistive random-access memory (RRAM) device, a ferroelectric random access memory (FRAM) device, and a magnetic random access memory (MRAM) device.

16. The learning method of claim 15, wherein the RRAM device has a structure in which a first metal layer, an insulator layer, and a second metal layer are vertically stacked.

17. The learning method of claim 10, wherein the first training data and the second training data are electrocardiogram signal data, and
the artificial neural network is trained to perform inference to classify characteristics of analysis target data, which is the electrocardiogram signal data collected through the device, into a preset category.

18. An analysis method based on an artificial neural network using a resistive element, comprising:
determining a weight of the artificial neural network through learning based on first training data and reflecting the determined weight in a first resistive element;
updating the weight of the artificial neural network through learning based on second training data collected through a device and reflecting the updated weight in the second resistive element; and
acquiring analysis target data using the device and performing inference on the analysis target data based on the artificial neural network.
